# EUROPÄISCHE PATENTANMELDUNG

(11) **EP 3 758 231 A1**
(43) Veröffentlichungstag der Anmeldung: **30.12.2020**
(21) Anmeldenummer: 20177015.3
(22) Anmeldetag: 28.05.2020
(51) Int. Cl.: H03K 17/955

(54) **KAPAZITIVER DREI-ELEKTRODEN-SENSOR ZUR SICHEREN FERNBEREICHSDETEKTION**

(30) Priorität: 28.06.2019 DE 102019209439
(71) Anmelder: Robert Bosch GmbH, 70442 Stuttgart (DE)
(72) Erfinder: Bonemberg, Adam, 70195 Stuttgart (DE); Fischer, Chris, 70435 Stuttgart (DE); Iske, Burkhard, 71272 Renningen (DE)

(57) **Zusammenfassung**

Kapazitive Sensoreinrichtung (2) zum Erfassen von Objekten (50), wobei die Sensoreinrichtung eine erste Elektrode (22) aufweist sowie eine Signalerzeugungseinrichtung (20), welche diese erste Elektrode (22) mit einem elektrischen Signal (S1) beaufschlagt, wodurch die erste Elektrode (22) ein elektrisches Feld (E1) ausgibt, sowie eine zweite Elektrode (24), welche von der ersten Elektrode (22) beabstandet ist, zur Aufnahme des von der ersten Elektrode (22) ausgegebenen elektrischen Feldes (E1). Erfindungsgemäß weist die Sensoreinrichtung (2) eine dritte Elektrode (26) auf, welche mit einem Bezugspotential der Sensoreinrichtung beaufschlagt ist.

## Beschreibung

Die vorliegende Erfindung bezieht sich auf eine Sensoreinrichtung und insbesondere eine Sensoreinrichtung, welche einen kapazitiven Sensor aufweist. Kapazitive Sensoren werden auf vielfältige Art zur Erkennung von dielektrischen und leitfähigen Objekten im Nahbereich eines elektrischen Feldes genutzt. Insbesondere zur Erkennung von Personen und Lebewesen eignet sich das kapazitive Wirkprinzip gut. Die Objekterkennung kann zur Realisierung von Komfortfunktionen, wie zum Beispiel bei berührungsempfindlichen Bildschirmen oder auch zur Realisierung von Sicherheitsfunktionen, wie zum Beispiel für die Mensch-Roboter-Kollaboration, eingesetzt werden.

Weitere Anwendungen sind beispielsweise Füllstandsensoren und Näherungsschalter, die in einer Prozesssteuerung Anwendung finden können.

Eine kapazitive Sensorik ermöglicht berührungslose Sicherheitsfunktionen, die einen sicheren Zustand einleiten, noch bevor es zu einer Krafteinwirkung auf Objekte im Gefahrenbereich kommt. Hierfür müssen die Sensoren eine hinreichend große Detektionsreichweite aufweisen, um Reaktions- und Verzögerungszeiten Rechnung tragen zu können.

Um Objekte sicher zu detektieren, eignen sich kapazitive Sensoriken, die nach dem Prinzip der projizierten wechselseitigen Kapazität (mutual capacitance) arbeiten und aus Elektrodenpaaren bestehen, bei denen in der Regel eine Elektrode ein veränderliches elektrisches Feld aufspannt bzw. ausgibt, und mittels einer zweiten Elektrode innerhalb des Feldes, der induzierte Verschiebungsstrom gemessen wird. Dabei erfasst diese Art der kapazitiven Sensorik auch Umgebungseinflüsse, wie etwa Luftfeuchtigkeit, Spritzwasser im Nahbereich des Sensors.

Die Erkennbarkeit von leitfähigen Objekten, wie beispielsweise Personen, ist mit Sensoren, die nach diesem Prinzip arbeiten, im Nahbereich sichergestellt, da das leitfähige oder dielektrische Objekt effektiv eine Verkürzung des Elektrodenabstands und damit eine Erhöhung des Verschiebestroms und somit eine Veränderung von Messwerten bewirkt. Im Fernbereich ist die Erkennbarkeit bei Sensoreinrichtungen nach diesem Prinzip stark von der kapazitiven und ohmschen Kopplung der Objekte an ein Bezugspotenzial abhängig. Wenn das Objekt nicht an das Bezugspotenzial gekoppelt ist, ist eine Fernbereichsdetektion nicht möglich. In diesem Fall bewirkt ein Einbringen eines Objekts im Fernbereich keine messbare Veränderung des Verschiebungsstromes einer der beiden und insbesondere der zweiten Elektrode.

Aufgrund von anwendungstypischen Gegebenheiten ist beispielsweise im Bereich der Maschinenabsicherung die Erde der Umgebung als Bezugspotenzial zu verwenden und anzunehmen, dass das zu detektierende Objekt hinreichend gut kapazitiv und oder ohmsch an die Umgebung gekoppelt ist. Dieser Fall wird unten verdeutlicht. Die gute Kopplung des Objekts bewirkt eine Verschiebung der Feldlinien in Richtung des Objekts und damit eine messbare Absenkung des Verschiebestroms in der zweiten Elektrode.

In der DE 10 2013 013 203 A1 und der DE 10 2013 013 204 A1 wird explizit ein Fahrzeug als Bezugspotenzial definiert. Aus der US 853510 A1 ist ein kapazitiver Drei-Elektroden-Sensor in zyklisch koaxialer Anordnung beschrieben, der jedoch noch keine hinreichende Lösung des Problems der Fernbereichserkennung anbietet.

Der vorliegenden Erfindung liegt daher die Aufgabe zugrunde, eine sichere Näherungserkennung von dielektrischen und insbesondere leitfähigen Objekten auch im Fernbereich einer kapazitiven Sensoreinrichtung und insbesondere weitestgehend unabhängig von der kapazitiven und ohmschen Kopplung des zu detektierenden Objekts an die Umgebung und/ oder auch unabhängig vom Bezugspotenzial der Umgebung zu erreichen. Dies wird durch die Gegenstände der unabhängigen Patentansprüche erreicht. Vorteilhafte Ausführungsformen und Weiterbildungen sind Gegenstand der Unteransprüche.

Eine erfindungsgemäße kapazitive Sensoreinrichtung zum Erfassen von Objekten weist eine erste Elektrode auf, sowie eine Signalerzeugungseinrichtung, welche diese erste Elektrode mit einem elektrischen Signal beaufschlagt, wodurch die erste Elektrode ein elektrisches Feld ausgibt. Weiterhin weist die Sensoreinrichtung eine zweite Elektrode auf, welche von der ersten Elektrode beabstandet ist und welche zur Aufnahme des von der ersten Elektrode ausgegebenen elektrischen Feldes dient.

Erfindungsgemäß weist die Sensoreinrichtung eine dritte Elektrode auf, welche mit einem Bezugspotenzial der Sensoreinrichtung beaufschlagt ist. Es wird daher vorgeschlagen, dass eine Sensoreinrichtung mit wenigstens drei Elektroden zum Einsatz kommt. Damit wird bevorzugt ein aus dem Stand der Technik bekannter Zwei-Elektroden-Sensor um eine dritte Elektrode erweitert, die bevorzugt mit einem Bezugspotenzial der Sensoreinrichtung verbunden ist.

Bei einer bevorzugten Ausführungsform ist diese dritte Elektrode in dem von der Sensoreinrichtung und insbesondere von der ersten Elektrode aufgespannten bzw. ausgegebenen elektrischen Feld angeordnet. Hierunter ist bevorzugt zu verstehen, dass ein von der ersten Elektrode gebildetes elektrisches Feld auch teilweise die besagte dritte Elektrode erreicht.

Ein derartiger Drei-Elektroden-Sensor eignet sich zur sicheren Annäherungskennung von Personen und Objekten, insbesondere bei allen Arten von Maschinen, Fortbewegungs- und Beförderungsmitteln, Schließ- und Trennvorrichtungen, Überwachungseinrichtungen und computergesteuerten Systemen, von denen Gefahren ausgehen, die durch sensorisch unterstützte Sicherheitsfunktionen gemindert oder ausgeschlossen werden können.

Bei einer bevorzugten Ausgestaltung ist auch die dritte Elektrode geerdet. Weiterhin ist es auch möglich, dass die Signalerzeugungseinrichtung mit dem Bezugspotenzial beaufschlagt wird und insbesondere ebenfalls geerdet ist. Bei einer bevorzugten Ausführungsform ist die dritte Elektrode mit dem gleichen Bezugspotential versehen wie die Signalerzeugungseinrichtung.

Bevorzugt ist die Signalerzeugungseinrichtung dazu geeignet und bestimmt ein sich änderndes Signal und insbesondere ein sich periodisch änderndes Signal auszugeben. Hierbei könnte es sich beispielsweise um eine sinusförmige Spannung oder auch um eine rechtecksförmige Spannung handeln.

Damit gibt die Signalerzeugungseinrichtung Signal gegenüber dem Bezugspotenzial und insbesondere gegenüber der Erdung aus.

Bei einer weiteren bevorzugten Ausführungsform ist die dritte Elektrode derart gestaltet und/oder angeordnet, dass eine kapazitive Kopplung zwischen der dritten Elektrode und dem zu erfassenden Objekt herstellbar ist. Dabei führt diese kapazitive Kopplung des Objekts dazu, dass das Objekt bei Eindringen in den Fernbereich der Sensoreinrichtung eine Verschiebung der Feldlinien bewirkt und auch eine Veränderung und insbesondere ein Absinken des Verschiebestroms in der zweiten Elektrode.

Unter einem Erfassen eines Objekts wird insbesondere eine Bestimmung einer Position dieses Objekts gegenüber der Sensoreinrichtung und insbesondere eines Abstandes des Objekts gegenüber der Sensoreinrichtung verstanden. Daneben ist es jedoch auch möglich, das Objekt hinsichtlich etwa seiner Oberflächengestalt zu erfassen. Daneben wäre es auch möglich, durch die Erfassung des Objekts Größen zu ermitteln, wie etwa eine Relativgeschwindigkeit des Objekts, insbesondere gegenüber der Sensoreinrichtung, eine Beschleunigung des Objekts, insbesondere gegenüber der Sensoreinrichtung, und eine Bewegungsrichtung des Objekts gegenüber der Sensoreinrichtung.

Bei einer weiteren bevorzugten Ausführungsform ist die dritte Elektrode näher an dem zu erfassenden Objekt angeordnet als die erste Elektrode und/ oder die zweite Elektrode. Besonders bevorzugt ist die dritte Elektrode näher an dem zu erfassenden Objekt angeordnet als die erste Elektrode und die zweite Elektrode. So könnte beispielsweise die dritte Elektrode bezüglich der beiden anderen Elektroden in Richtung des zu detektierenden Objekts versetzt sein.

So wären Ausgestaltungen denkbar, bei denen sich die dritte Elektrode näher an dem zu detektierenden Objekt befindet und bevorzugt in Richtung des zu detektierenden Objekts wirksam ist, das heißt die Fläche der dritten Elektrode zumindest auch in Richtung des zu detektierenden Objekts weist. Dies kann auch dann gegeben sein, wenn die dritte Elektrode von den beiden weiteren Elektroden aus gesehen hinter dem zu detektierenden Objekt angeordnet ist. Bei dieser Ausgestaltung befindet sich das zu detektierende Objekt zwischen der ersten und zweiten Elektrode einerseits und der dritten Elektrode andererseits.

Bei einer weiteren bevorzugten Ausführungsform weist die dritte Elektrode eine größere Fläche auf, als die erste Elektrode und/ oder die zweite Elektrode.

Bei einer weiteren bevorzugten Ausführungsform weist die dritte Elektrode eine Fläche auf, die größer ist als die Summe der Flächen der ersten Elektrode und der zweiten Elektrode.

Weiterhin ist es auch möglich, dass die dritte Elektrode nachrüstbar ist und beispielsweise bei vielen Sensorapplikationen auch mit geringem Aufwand durch Einbeziehung und Anbindung bereits vorhandener mechanischer Teile realisierbar ist.

Bei einer weiteren bevorzugten Ausführungsform sind die drei Elektroden in einer gemeinsamen Ebene angeordnet. Bevorzugt sind diese drei Elektroden in dieser Ebene versetzt zueinander. Bevorzugt sind dabei die ersten beiden Elektroden gegenüber einander horizontal, vertikal oder diagonal versetzt. Die dritte Elektrode kann oberhalb, unterhalb, seitlich oder auch die anderen beiden Elektroden umgebend ausgestaltet sein. Es wäre jedoch auch möglich, dass die erste Elektrode und die zweite Elektrode in einer ersten Ebene angeordnet sind und die dritte Elektrode in einer zweiten Ebene angeordnet ist, wobei sich diese Ebenen unterscheiden.

Unter einem angeordnet sein der Elektrode in einer bestimmten Ebene wird verstanden, dass diejenige Fläche der Elektrode, welche die elektrischen Felder ausgibt oder aufnimmt, in der besagten Ebene angeordnet ist oder geringfügig jedoch parallel gegenüber dieser Ebene versetzt ist.

Weiterhin ist es auch möglich, dass die dritte Elektrode die erste Elektrode und die zweite Elektrode abdeckt, allerdings nicht in einer Wirkrichtung abdeckt. In diesem Falle ist die dritte Elektrode noch weiter von dem zu untersuchenden Objekt entfernt als die erste und/ oder zweite Elektrode.

Bevorzugt sind diese beiden Ebenen parallel zueinander.

Bevorzugt deckt die dritte Elektrode die ersten beiden Elektroden nicht in einer Wirkrichtung ab, also in einer weg von Elektroden und hin zu dem Objekt weisenden Richtung ab. Dabei kann dieses Abdecken wie oben erwähnt vollständig erfolgen.

Bei einer weiteren vorteilhaften Ausführungsform ist die dritte Elektrode dreidimensional ausgebildet. So kann beispielsweise die dritte Elektrode eine quaderförmige Struktur aufweisen und die erste und zweite Elektrode können insbesondere an einer Außenoberfläche der dritten Elektrode angeordnet sein. So kann die dritte Elektrode auch mehrere Abstrahl- und/oder Wirkflächen aufweisen, die in unterschiedliche Richtungen weisen

Die vorliegende Erfindung ist weiterhin auf ein Verfahren zum Betreiben einer kapazitiven Sensoreinrichtung zur Erfassung von Objekten gerichtet, wobei mittels einer Signalerzeugungseinrichtung eine erste Elektrode mit einem ersten elektrischen Signal beaufschlagt wird, wodurch die erste Elektrode ein elektrisches Feld ausgibt, und wobei mit einer zweiten Elektrode, welche von der ersten Elektrode beabstandet ist, das von der ersten Elektrode ausgegebene elektrische Feld aufgenommen wird.

Erfindungsgemäß weist die Sensoreinrichtung eine dritte Elektrode auf, welche mit einem Bezugspotential der Sensoreinrichtung beaufschlagt wird.

Bevorzugt wird auch die Signalerzeugungseinrichtung mit diesem Bezugspotential beaufschlagt. Bei einem weiteren bevorzugten Verfahren wird die dritte Elektrode in dem Feldbereich des von der Sensoreinrichtung und/oder der ersten Elektrode ausgegebenen Feldes angeordnet und/oder die Feldlinien des von der Sensoreinrichtung ausgegebenen elektrischen Feldes erreichen auch die dritte Elektrode.

Bei einem weiteren bevorzugten Verfahren wird eine kapazitive Kopplung zwischen der dritten Elektrode und dem zu erfassenden Objekt hergestellt.

Bei einer weiteren vorteilhaften Ausführungsform weist die Sensoreinrichtung eine Auswerteinheit auf, welche die von der zweiten Elektrode aufgenommenen Signale auswertet.

Die hier beschriebene Drei-Elektroden-Sensoreinrichtung löst das Problem der nicht-Erkennbarkeit von schwach oder gar nicht an die Umgebung gekoppelten Objekten, was insbesondere bei der Beurteilung der funktionalen Sicherheit eines Sensorsystems ein Ausschließkriterium sein kann. Die Verbesserung der Objektkopplung an das Bezugsobjekt bzw. das Bezugspotenzial durch die dritte Elektrode führt dazu, dass das Objekt bei größeren Abschnitten detektiert wird. Gegenüber den aus dem Stand der Technik bekannten Zwei-Elektroden-Sensoreinrichtungen weist eine Drei-Elektroden-Sensoreinrichtung, insbesondere eine solche, die wie hier nach dem Prinzip der projizierten wechselseitigen Kapazität arbeitet (english mutual capacitance) die folgenden Vorteile auf.

Zum einen wird das nicht-Erkennen von Objekten aufgrund deren unzureichender Kopplung an ein Bezugspotenzial vermieden.

Daneben kann eine höhere Reichweite bei einer gleichbleibenden Elektrodengröße erreicht werden und auch bei einem gleichbleibenden Elektronenabstand. Auf diese Weise wird ein Funktionsvorteil erreicht.

Weiterhin können kleinere Elektroden und auch kleinere Elektrodenabstände bei gleichbleibender Reichweite eingesetzt werden.

Daneben kann auch die Integration vereinfacht werden und eine Kosteneinsparung erreicht werden.

Weiterhin erlauben auch höhere Reichweiten im Kontext von sicherheitsbezogenen Systemen höhere Geschwindigkeiten einer gefahrbringenden Bewegung und dadurch zum Beispiel kürzere Taktzeiten der Maschinen oder Effizienzgewinn durch eine schnellere Prozessabwicklung. Daneben entsteht auch ein Vorteil hinsichtlich der Wirtschaftlichkeit.

Weitere Vorteile und Ausführungsformen ergeben sich aus den beigefügten Figuren:

### Darin zeigen:

- Fig. 1: eine Darstellung einer Sensoreinrichtung nach dem Stand der Technik;
- Fig. 2: eine Darstellung zur Veranschaulichung einer Objekterkennung im Nahfeldbereich;
- Fig. 3: eine Darstellung einer Sensoreinrichtung im Fernfeldbereich;
- Fig. 4: eine Darstellung eines Zwei-Elektroden-Sensors, wobei auch das zu erfassende Objekte beispielsweise am Boden gekoppelt ist;
- Fig. 5: eine schematische Darstellung einer erfindungsgemäßen Sensoreinrichtung;
- Fig. 6a - 6d: vier verschiedene mögliche Anordnungen der einzelnen Elektroden.

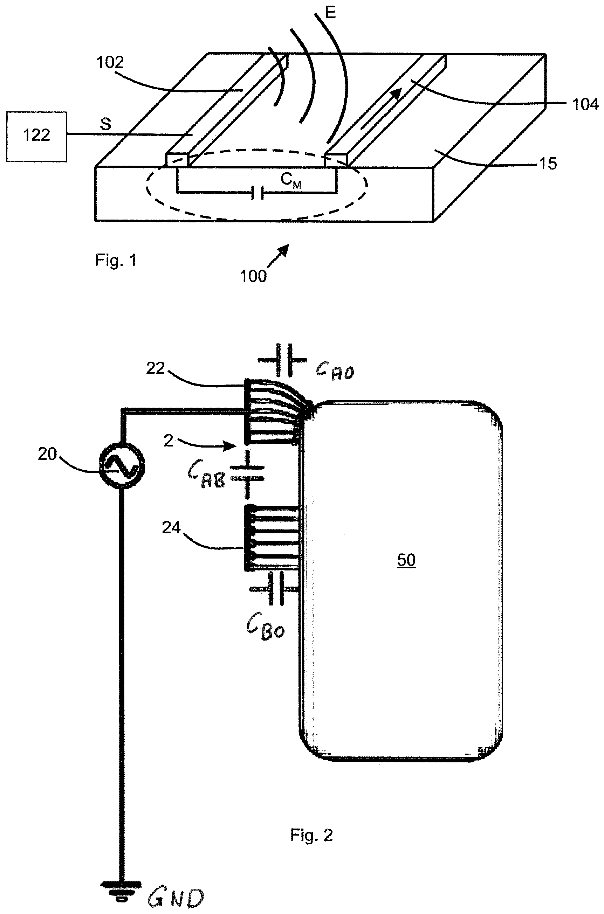

Figur 1 zeigt eine schematische Darstellung einer Sensoreinrichtung 100 nach dem Stand der Technik. Diese Sensoreinrichtung 100 weist eine erste Elektrode 102 auf sowie eine zweite Elektrode 104. Diese Elektroden 102, 104 sind an einem gemeinsamen Träger 15 angeordnet. Das Bezugszeichen 122 kennzeichnet eine Signalerzeugungseinrichtung, welche an die erste Elektrode 102 ein Signal S ausgibt. Dieses Signal S erzeugt ein elektrisches Feld E. Dieses elektrische Feld E wird teilweise von der zweiten Elektrode 104 aufgenommen und auf diese Weise ein Verschiebestrom induziert, der entsprechend gemessen werden kann. Dabei wirken sich auf das elektrische Feld auch etwa Objekte aus, welche in einem Bereich zwischen Elektroden 102 oder 104 sind, jedoch auch solche, die in einem entfernten Bereich zwischen den beiden Elektroden 102 und 104 befindlich sind.

Allerdings wirken sich auf die Messung auch Störungen bzw. Objekte aus, wie etwa Wasserfilme, Verschmutzungen oder dergleichen.

Figur 2 zeigt eine Darstellung zur Veranschaulichung eines Zwei-Elektroden-Sensors in einem Nahbereich. Dabei befindet sich ein zu detektierendes Objekt 50 im Nahbereich der in ihrer Gesamtheit mit 2 bezeichneten Sensoreinrichtung. Diese Sensoreinrichtung weist eine erste Elektrode 22 auf sowie eine zweite Elektrode 24, zwischen denen sich ein elektrisches Feld E ausbildet. Weiterhin bezeichnet das Bezugszeichen C_{AB} die Kapazität zwischen den Elektroden 22 und 24, das Bezugszeichen C_{A0} kennzeichnet die Kapazität zwischen dem Objekt 50 und der ersten Elektrode 22 und das Bezugszeichen C_{B0} die Kapazität zwischen dem Objekt 50 und der zweiten Elektrode 24.

Das Bezugszeichen GND kennzeichnet das gemeinsame Potenzial, hier die Erdung.

Durch das Objekt 50 tritt eine Verkürzung des Elektrodenabstands auf und damit effektiv eine Erhöhung des Verschiebungsstroms und damit auch eine Veränderung eines Messwerts, der von der Sensoreinrichtung ausgegeben und ausgewertet wird.

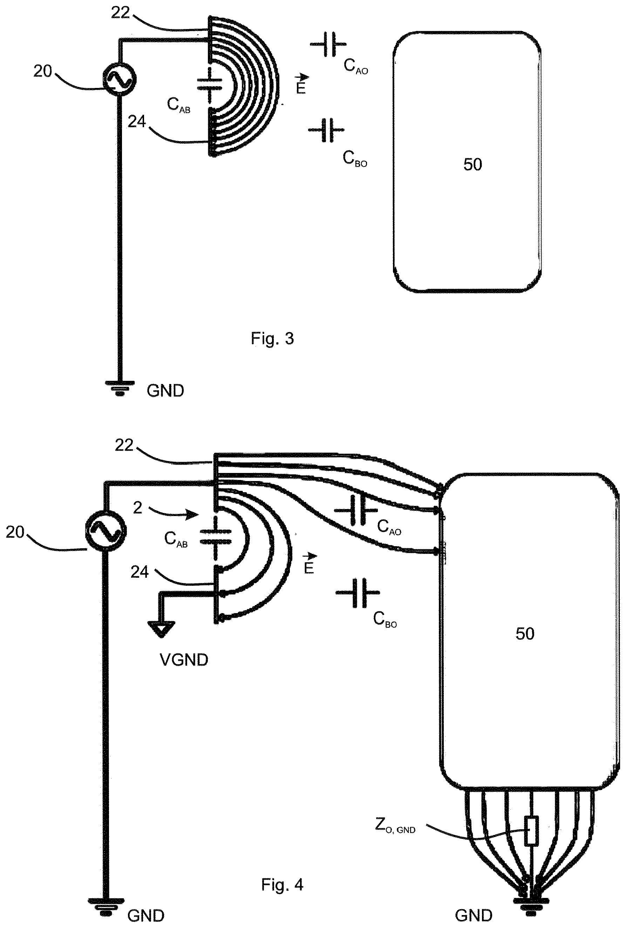

Figur 3 zeigt eine Veranschaulichung zur Detektion im Fernfeld. Man erkennt, dass wenn das Objekt 50 nicht an das Bezugspotenzial gekoppelt ist, eine Fernbereichsdetektion nicht möglich ist. Das Einbringen des Objekts 50 im Fernbereich führt zu keinen messbaren Veränderungen des Verschiebungsstroms in der zweiten Elektrode.

Figur 4 zeigt eine Situation, bei der auch das zu detektierende Objekt 50 geerdet ist bzw. auf das gleiche Bezugspotenzial gelegt ist wie die Sensoreinrichtung 2. Diese gute Kopplung, die durch das Bezugszeichen Z_{O-GND} gekennzeichnet ist, bewirkt eine Verschiebung der Feldlinien in Richtung des Objekts und damit auch eine messbare Absenkung des Verschiebestroms in der zweiten Elektrode 24, wie durch Figur 4 gezeigt. Dabei ist auch die zweite Elektrode an ein Bezugspotential VGND gelegt.

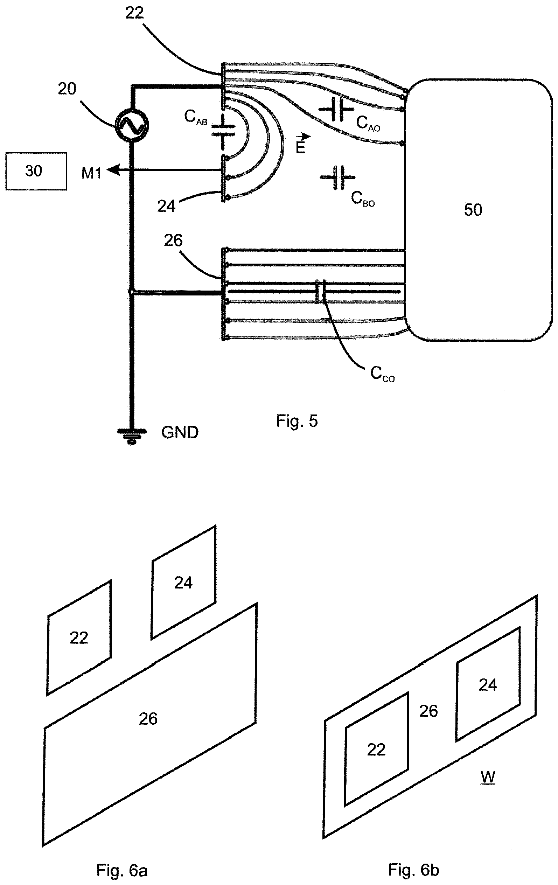

Figur 5 zeigt eine schematische Darstellung einer erfindungsgemäßen Sensoreinrichtung. Dabei erkennt man, dass hier neben der ersten Elektrode 22 und der zweiten Elektrode 24 auch noch eine dritte Elektrode 26 vorgesehen ist. Diese liegt an dem Bezugspotenzial GND der Sensoreinrichtung bzw. der Signalerzeugungseinrichtung 20. Diese dritte Elektrode 26 wird in das Feld E, welches von dem Sensor aufgespannt wird, eingebracht. Die Kapazität C_{CO}, die zwischen der dritten Elektrode 26 und dem Objekt gebildet wird, beeinflusst ebenfalls das von der Elektrode 24 aufgenommene elektrische Feld und damit die Messsignale M1, die von der zweiten Elektrode 26 ausgegeben werden.

Diese Messignale können von einer Auswerteeinrichtung 30 aufgenommen werden und aus dieser Auswertung kann etwa eine Entfernung des Objekts 50 von der Sensoreinrichtung ermittelt und/oder geschätzt werden. Zum Zwecke dieser Auswertung können in der Auswertung Referenzdaten bzw. Referenzwerte abgespeichert werden und die aufgenommenen Messignale können mit diesen Referenzdaten verglichen werden, um so einen Wert auszugeben, der für eine Entfernung des Objekts von der Sensoreinrichtung 2 charakteristisch ist.

Die Figuren 6a bis 6d zeigen mögliche Anordnungen der einzelnen Elektroden. Bei der in Figur 6a gezeigten Ausgestaltung sind die erste und die zweite Elektrode nebeneinander angeordnet und unter diesen ist die dritte Elektrode 26 angeordnet. Die dritte Elektrode weist jedoch dabei eine größere Fläche auf, als die beiden ersten und zweiten Elektroden 22 und 24 auch eine größere Fläche als die Gesamtfläche der beiden Elektroden 22, 24.

Bei dieser Ausgestaltung aus Figur 6a können diese drei Elektroden 22, 24 und 26 in der gleichen Ebene angeordnet sein, es wäre jedoch auch möglich, dass die dritte Elektrode gegenüber der ersten und zweiten Elektrode 22 und 24 nach vorne, das heißt in Richtung des zu detektierenden Objekts angeordnet ist.

Bei der in Figur 6b gezeigten Anordnung sind die beiden Elektroden 22 und 24 hier nebeneinander und wiederum planar in einer Ebene angeordnet. Die Elektrode 26 ist ebenfalls planar und großflächig in einer weiteren Ebene platziert und kann hier die beiden Elektroden 22 und 24 teilweise oder vollständig zur Abschirmung des Feldes in einer nicht-Wirkrichtung überdecken. Die nicht-Wirkrichtung liegt hier in Figur 6b hinter den Elektroden 22, 24 und 26 und die Wirkrichtung ist durch das Bezugszeichen W gekennzeichnet.

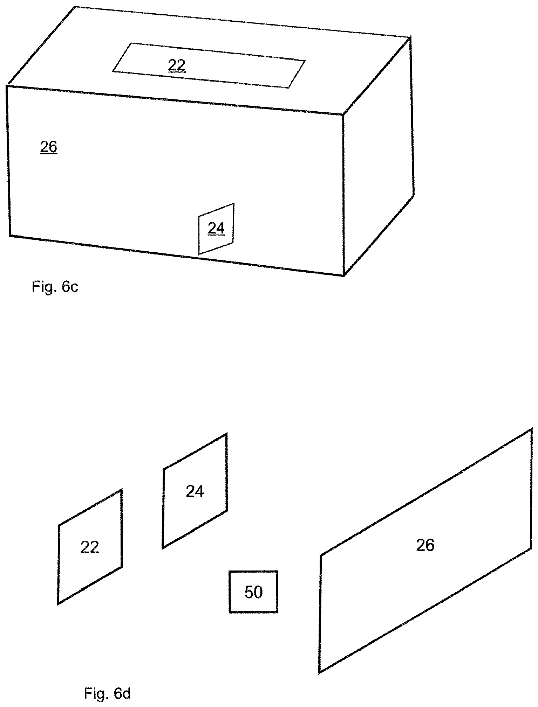

Bei der in Figur 6c gezeigten Anordnung sind die Elektroden 22 und 24 in beliebiger räumlicher Lage formgestaltet. Die Elektrode 26 ist räumlich komplex, das heißt hier beispielsweise quaderförmig gestaltet und kann die Elektrode 22 und 24 teilweise oder vollständig zur Abschirmung in nicht-Wirkrichtung überdecken. Dabei kann die dritte Elektrode 26 mehrere Oberflächen aufweisen die als Aufnahmeflächen für ein elektrisches Feld dienen

Figur 6d schließlich zeigt eine Anordnung, bei der die erste und die zweite Elektrode 22 und 24 auf einer Seite bezüglich des Objekts 50 angeordnet sind und die dritte Elektrode 26 auf der anderen Seite. Das Objekt 50 ist anders als in Figur 4 gezeigt auch dreidimensional gebildet. Damit befindet sich die dritte Elektrode gesehen von dem Elektrodenpaar 22 und 24 hier hinter dem zu detektierenden Objekt 50.

Es wären neben den in den Figuren gezeigten Anordnungen auch weitere Anordnungen denkbar, etwa solche Anordnungen, bei denen die einzelnen Elektroden und insbesondere die dritte Elektrode gegenüber der ersten und zweiten Elektrode gewinkelt angeordnet sind. Bevorzugt sind jedoch die Ebenen aller Elektroden bzw. deren Wirkebenen zumindest zueinander parallel.

Die Anmelderin behält sich vor, sämtliche in den Anmeldungsunterlagen offenbarten Merkmale als erfindungswesentlich zu beanspruchen, sofern sie einzeln oder in Kombination gegenüber dem Stand der Technik neu sind. Es wird weiterhin darauf hingewiesen, dass in den einzelnen Figuren auch Merkmale beschrieben wurden, welche für sich genommen vorteilhaft sein können. Der Fachmann erkennt unmittelbar, dass ein bestimmtes in einer Figur beschriebenes Merkmal auch ohne die Übernahme weiterer Merkmale aus dieser Figur vorteilhaft sein kann. Ferner erkennt der Fachmann, dass sich auch Vorteile durch eine Kombination mehrerer in einzelnen oder in unterschiedlichen Figuren gezeigter Merkmale ergeben können.

## Patentansprüche

1. Kapazitive Sensoreinrichtung (2) zum Erfassen von Objekten (50), wobei die Sensoreinrichtung eine erste Elektrode (22) aufweist sowie eine Signalerzeugungseinrichtung (20), welche diese erste Elektrode (22) mit einem elektrischen Signal (S1) beaufschlagt, wodurch die erste Elektrode (22) ein elektrisches Feld (E1) ausgibt, sowie eine zweite Elektrode (24), welche von der ersten Elektrode (22) beabstandet ist, zur Aufnahme des von der ersten Elektrode (22) ausgegebenen elektrischen Feldes (E1)
**dadurch gekennzeichnet, dass**
die Sensoreinrichtung (2) eine dritte Elektrode (26) aufweist, welche mit einem Bezugspotential der Sensoreinrichtung beaufschlagt ist.

2. Kapazitive Sensoreinrichtung (2) nach Anspruch 1,
**dadurch gekennzeichnet, dass**
die dritte Elektrode in dem Feldbereich des von der Sensoreinrichtung (2) ausgegebenen elektrischen Feldes (E1) angeordnet ist.

3. Kapazitive Sensoreinrichtung nach Anspruch 1 oder 2,
**dadurch gekennzeichnet, dass**
die dritte Elektrode (26) geerdet ist.

4. Kapazitive Sensoreinrichtung (2) nach wenigstens einem der vorangegangenen Ansprüche,
**dadurch gekennzeichnet, dass**
die dritte Elektrode (26) derart gestaltet ist, dass eine kapazitive Kopplung zwischen der dritten Elektrode (26) und dem Objekt (50) herstellbar ist.

5. Kapazitive Sensoreinrichtung (2) nach wenigstens einem der vorangegangenen Ansprüche,
**dadurch gekennzeichnet, dass**
die dritte Elektrode näher an dem zu erfassenden Objekt angeordnet ist als die erste Elektrode (22) und/oder die zweite Elektrode (24).

6. Kapazitive Sensoreinrichtung (2) nach wenigstens einem der vorangegangenen Ansprüche,
**dadurch gekennzeichnet, dass**
die dritte Elektrode (26) eine größere Fläche aufweist als die erste Elektrode (22) und/oder die dritte Elektrode (26) eine größere Fläche aufweist als die zweite Elektrode (24).

7. Kapazitive Sensoreinrichtung (2) nach dem vorangegangen Anspruch.
**dadurch gekennzeichnet, dass**
die dritte Elektrode (26) eine Fläche aufweist, die größer ist als die Summe der Flächen der ersten Elektrode (22) und der zweiten Elektrode.

8. Kapazitive Sensoreinrichtung (2) wenigstens einem der vorangegangenen .
**dadurch gekennzeichnet, dass**
die drei Elektroden planar in einer Ebene (E) angeordnet sind.

9. Kapazitive Sensoreinrichtung (2) nach wenigstens einem der vorangegangenen Ansprüche,
**dadurch gekennzeichnet, dass**
die erste Elektrode (22) und die zweite Elektrode (24) in einer Ebene angeordnet sind und die dritte Elektrode (26) in einer zweiten Ebene liegt.

10. Verfahren zum Betreiben einer kapazitiven Sensoreinrichtung (2) zur Erfassung von Objekten wobei mittels einer Signalerzeugungseinrichtung (20) eine erste Elektrode (22) mit einem ersten elektrischen Signal (S1) beaufschlagt wird, wodurch die erste Elektrode (22) ein elektrisches Feld (E1) ausgibt, und wobei mit einer zweiten Elektrode (24), welche von der ersten Elektrode (2) beabstandet ist, das von der ersten Elektrode (22) ausgegebene elektrische Feld (E1) aufgenommen wird,
**dadurch gekennzeichnet, dass**
die Sensoreinrichtung (1) eine dritte Elektrode (26) aufweist, welche mit einem Bezugspotential der Sensoreinrichtung (2) beaufschlagt ist,
wobei hierdurch eine Fernfelderkennung der Objekte ermöglicht ist.
